Europäisches Patentamt

European Patent Office

Office européen des brevets

(19)

(11) Veröffentlichungsnummer: **0 224 310 B1**

(12) **EUROPÄISCHE PATENTSCHRIFT**

(45) Veröffentlichungstag der Patentschrift: **26.02.92**

(21) Anmeldenummer: **86202075.7**

(22) Anmeldetag: **24.11.86**

(51) Int. Cl.⁵: $G01R\ 33/48$

(54) **Kernspintomographieverfahren und Anordnung zur Durchführung des Verfahrens.**

(30) Priorität: **29.11.85 DE 3542215**

(43) Veröffentlichungstag der Anmeldung:
**03.06.87 Patentblatt 87/23**

(45) Bekanntmachung des Hinweises auf die
Patenterteilung:
**26.02.92 Patentblatt 92/09**

(84) Benannte Vertragsstaaten:
**BE DE FR GB IT NL SE**

(56) Entgegenhaltungen:
**EP-A- 0 213 614**

**L'ONDRE ELECTRIOUE, Band 65, Nr. 4, Juli-August 1985, Seiten 70-83, Paris, FR; A. BRIGUET et al.: "Bases de l'imagerie par résonance magnétique nucléaire"**

**RADIOLOGY, Band 153, Oktober 1984, Seiten 189-194, RSNA, US; W. THOMAS DIXON: "Simple proton spectroscopic imaging"**

**MAGNETIC RESONANCE IN MEDICINE, Band 2, Nr. 5, Oktober 1985, Seiten 428-436, Academic Press, Inc., New York, US; L. AXEL et al.: "Chemical-shift magnetic resonance imaging of two-line spectra by gradient rever-**

sal"

(73) Patentinhaber: **Philips Patentverwaltung GmbH**
**Wendenstrasse 35 Postfach 10 51 49**
**W-2000 Hamburg 1(DE)**

(84) Benannte Vertragsstaaten:
**DE**

(73) Patentinhaber: **N.V. Philips' Gloeilampenfabrieken**
**Groenewoudseweg 1**
**NL-5621 BA Eindhoven(NL)**

(84) Benannte Vertragsstaaten:
**BE FR GB IT NL SE**

(72) Erfinder: **McKinnon, Graeme**
**Höschgasse 62**
**CH-8008 Zürich(CH)**

(74) Vertreter: **Hartmann, Heinrich, Dipl.-Ing. et al**
**Philips Patentverwaltung GmbH Wendenstrasse 35 Postfach 10 51 49**
**W-2000 Hamburg 1(DE)**

## Beschreibung

Die Erfindung betrifft ein Kernspintomographieverfahren, bei dem in einer Vielzahl von Sequenzen Echosignale für die Rekonstruktion der räumlichen Dichteverteilung in einem Untersuchungsbereich gewonnen werden, wobei jede Sequenz eine Selektionsphase, in der ein einziger Hochfrequenzimpuls in Anwesenheit eines magnetischen Gradientenfeldes in den Untersuchungsbereich eingestrahlt wird, eine darauf folgende Kodierungsphase, in der ein magnetisches Gradientenfeld mit von Sequenz zu Sequenz nach Betrag bzw. Richtung verändertem Gradienten auf den Untersuchungsbereich einwirkt und eine daran anschließende Lesephase umfaßt, in der in Anwesenheit eines magnetischen Gradientenfeldes das im Untersuchungsbereich erzeugte Kernspin-Echosignal abgetastet wird, wonach aus dem Echosignal ein von der Protonenverteilung abhängiges Bild errechnet wird, wobei als letzter Schritt die Bildwerte für die einzelnen Bildpunkte des Bildes durch Betragsbildung ermittelt werden, sowie eine Anordnung zur Durchführung eines solchen Verfahrens.

Ein solches Verfahren und eine solche Anordnung sind aus der Zeitschrift "Phys. Med. Biol.", Vol. 25 (l980), Seiten 75l bis 756 bekannt. Dabei wird zwischen der Selektionsphase und der Lesephase u.a. ein Gradientenfeld erzeugt, dessen Gradient in der gleichen Richtung verläuft, jedoch das entgegengesetzte Vorzeichen hat wie der Gradient des in der Lesephase wirksamen magnetischen Gradientenfeldes. Das zeitliche Integral über dieses Feld hat einen definierten Wert. Wenn das Integral in der Lesephase dem Betrage nach gleich groß ist, tritt ein Echosignal auf, das zur Bildrekonstruktion benutzt wird.

Da nicht nur die Amplitude, sondern auch die Phasenlage des Echosignals für die Rekonstruktion wichtig ist, wird das Echosignal im allgemeinen in zwei zueinander um $90^\circ$ in der Phase versetzte Signalkomponenten zerlegt, die - zusammen mit den entsprechenden Komponenten der bei den anderen Sequenzen erhaltenen Echosignale - eine Fourier-Transformation unterzogen werden, aus der für jeden Bildpunkt ein wiederum aus zwei Komponenten bestehender Bildwert ermittelt wird. Die relative Größe dieser Komponenten hängt u.a. von der Feldstärke des Magnetfeldes in dem betreffenden Bildpunkt ab. Aufgrund von Feldinhomogenitäten können die beiden Komponenten daher für zwei auseinander liegende Bildpunkte unterschiedliche Werte aufweisen, obwohl im Untersuchungsbereich in beiden Fällen die gleiche Protonendichte gegeben ist. Die dadurch bedingten Verfälschungen im rekonstruierten Bild werden dadurch vermieden, daß der Betrag aus den beiden Komponenten gebildet wird (durch Summierung der Quadrate der beiden Komponenten).

Das bekannte Verfahren der eingangs genannten Art, das oft auch als Spin-Warp-Verfahren bezeichnet wird, ermöglicht eine schnelle Erfassung der Echosignale, weil bei jeder Sequenz nur ein Hochfrequenzimpuls verabfolgt wird. Auf der anderen Seite ergeben sich bei einem solchen Verfahren Kontrastverfälschungen, wenn im Untersuchungsbereich gleichzeitig Fett und Wasser vorhanden sind. Die Larmorfrequenz von an Wasser gebundenen Wasserstoffprotonen - diese Frequenz wird im folgenden auch als "Wasserfrequenz" bezeichnet - und die Larmorfrequenz von an Fett gebundenen Wasserstoffprotonen - im nachfolgenden auch als "Fettfrequenz" bezeichnet - unterscheiden sich nämlich um rund 3,3 ppm, so daß die geschilderten Verfälschungen entstehen können. Wenn diese Kontrastverfälschungen verhindert werden sollen, muß entweder ein Bild erzeugt werden, das von der Fettverteilung unabhängig ist - dieses Bild wird im folgenden auch als Fettbild bezeichnet - , oder ein Bild, das von der Wasserverteilung unabhängig ist - im nachfolgenden auch Wasserbild genannt.

Ein Verfahren zur Erzeugung von Wasser- bzw. Fettbildern ist aus "Radiology", Vol. l53(l984), Seiten l89 bis l94 bekannt. Bei dem bekannten Verfahren folgt nach einem ersten $90^\circ$-Impuls in der Selektionsphase nach der Kodierungsphase ein l80$^\circ$-Hochfrequenzimpuls. Dadurch wird ein (Spin-) Echosignal in einem Abstand von dem l80$^\circ$-Impuls erzeugt, der dem zeitlichen Abstand des l80$^\circ$-Impulses von dem $90^\circ$-Impuls entspricht. Jede Sequenz wird zweimal wiederholt, wobei in der einen Sequenz der zeitliche Abstand zwischen den beiden Hochfrequenzimpulsen gegenüber dem entsprechenden Abstand in der anderen Sequenz um eine Zeitspanne verschoben wird, die gleich einem Viertel des Kehrwertes der Differenz von Wasser- und Fettfrequenz ist. Die bei jeder der beiden Sequenzen auftretenden Echosignale werden zur Rekonstruktion je eines Bildes benutzt. Das Wasser- bzw. Fettbild ergibt sich aus diesen beiden Bildern durch Summation- bzw. Differenzbildung. Eine Betragsbildung wie bei dem eingangs genannten Verfahren ist bei diesem Verfahren nicht erforderlich.

Ein Nachteil dieses Verfahrens zur Erzeugung von getrennten Fett- bzw. Wasserbildern besteht darin, daß jede Sequenz neben einem $90^\circ$-Impuls einen l80$^\circ$-Impuls umfaßt. Dieser Hochfrequenzimpuls enthält relativ viel Energie, die zu unerwünschten Erwärmungen des Untersuchungsbereichs führen kann. Außerdem dauern die Sequenzen relativ lange.

Aufgabe der vorliegenden Erfindung ist es, ein Verfahren der eingangs genannten Art so auszugestalten, daß mit nur einem Hochfrequenzimpuls pro Sequenz getrennte Fett- bzw. Wasserbilder erzeugt werden können. In den Ansprüchen 1 und 2 ist je eine Lösung dieser Aufgabe beschrieben.

Es sei an dieser Stelle erwähnt, daß aus der Zeitschrift L'ONDE ELECTRIQUE, Band 65, Nr. 4, Fig. 13, ein Verfahren der eingangs genannten Art bekannt ist, bei dem jede Sequenz ebenfalls zweimal durchgeführt wird (wie bei der Lösung nach Anspruch 1). Bei der ersten Sequenz beginnt die Abtastung des Kernresonanzsignals, wenn die Phasenverschiebung zwischen den an Fett und an Wasser gebundenen Protonen gerade 180° beträgt. Bei der zweiten Sequenz sind das Gradientenfeld in der Lesephase bzw. das zuvor in entgegengesetzter Richtung verlaufende Gradientenfeld so bemessen, daß sich der zeitliche Abstand zwischen dem Hochfrequenzimpuls und dem Beginn der Abtastung des Echosignals gegenüber der ersten Sequenz um einen Zeitraum verschiebt, der gleich dem 0,08-fachen des Kehrwerts der Differenz der Larmorfrequenz von an Wasser bzw. an Fett gebundenen Wasserstoffprotonen ist. Aus der Summe bzw. aus der Differenz der Bilder, die aus den ersten bzw. den zweiten Sequenzen abgeleitet werden, sollen sich getrennte Fett- bzw. Wasserbilder ergeben.

In der Praxis ist das geschilderte Verfahren nicht funktionsfähig, weil sich bei der angegebenen Verzögerung der Abtastung des Echosignals bei der ersten und der zweiten Sequenz die Phasendifferenz von an Fett und an Wasser gebundenen Protonen sich nur um knapp 30° ändern kann, so daß aus den Summen oder den Differenzen der mit den ersten bzw. den zweiten Sequenzen gewonnenen Bilder keine getrennten Fett/Wasserbilder erzeugt werden können. Es kommt hinzu, daß bei der ersten Sequenz der zeitliche Abstand zwischen dem Hochfrequenzimpuls und dem Echosignal so gewählt sein muß, daß die Phasendifferenz gerade 180° beträgt. Insoweit ist die zeitliche Lage vorgegeben und kann nicht den sonstigen Erfordernissen (z.B. der Dauer des Phasenkodierungsgradienten usw.) angepaßt werden.

Die Erfindung basiert auf der Erkenntnis, daß der zeitliche Abstand zwischen dem Echosignal und dem Hochfrequenzimpuls von dem Gradientenfeld in der Lesephase bzw. dem vorher in der entgegengesetzten Richtung wirksamen Gradientenfeld abhängt. Durch geeignete Variation eines oder beider Gradientenfelder kann erreicht werden, daß der zeitliche Abstand des Echosignals in bezug auf den Hochfrequenzimpuls (wenn hier und im folgenden von dem zeitlichen Abstand zwischen Impulsen bzw. Signalen die Rede ist, ist damit der zeitliche Abstand zwischen den zeitlichen Mitten der Signale gemeint) variiert wird. Die auf den Wasseranteil zurückzuführende Komponenten der Echosignale haben bei den beiden Sequenzen die gleiche Phasenlage - falls die Frequenz des Hochfrequenzimpulses der Wasserfrequenz entspricht. Die auf den Fettanteil zurückzuführenden Komponenten in den beiden Echosignalen haben hingegen eine entgegengesetzte Phasenlage - falls die Verschiebung des Echosignals durch die erläuterte Variation des Gradientenfeldes gerade der Hälfte des Kehrwertes der Differenz der Larmorfrequenzen von Fett und Wasser entspricht. Wenn daher die Rekonstruktion der Dichteverteilung mittels der Summe oder der Differenz der Echosignale der beiden Sequenzen erfolgt, ergibt sich ein Wasser- bzw. ein Fettbild.

Während bei dem ersten Verfahren die beiden Echosignale in zwei Sequenzen erzeugt werden (wobei für jeden Hochfrequenzimpuls nur ein Echosignal abgetastet wird), werden bei der zweiten Lösung beide Echosignale in nur einer Sequenz (d.h. durch nur einen Hochfrequenzimpuls) erzeugt. Die zweite Lösung ist zwar schneller, da nur die halbe Anzahl von Sequenzen erforderlich ist, doch führt sie nur dann nicht zu einer Verschlechterung des räumlichen Auflösungsvermögens, wenn das zeitliche Integral über das in den Lesephasen jeweils wirksame magnetische Gradientenfeld während einer Halbschwingung nicht verringert werden muß.

Die Summe bzw. die Differenz kann gebildet werden, indem zunächst die beiden Echosignale summiert bzw. voneinander subtrahiert werden und anschließend einem üblichen Rekonstruktionsverfahren, z.B. einer Fourier-Transformation, unterworfen werden. Da ein solches Rekonstruktionsverfahren jedoch ein linearer Prozeß ist, können auch die beiden Sequenzen zur Erzeugung von zwei Bildern herangezogen werden, die anschließend - zur Bildung der Summe bzw. der Differenz der Echosignale der beiden Sequenzen - bildpunktweise summiert bzw. voneinander subtrahiert werden. In beiden Fällen muß anschließend für jeden Bildpunkt der Betrag gebildet werden.

Eine Anordnung zur Durchführung des einen Verfahrens umfaßt Mittel zur Erzeugung eines stationären homogenen Magnetfeldes, einer Hochfrequenz-Spulenanordnung zur Erzeugung von Hochfrequenzimpulsen, Gradientenspulen zur Erzeugung von in Richtung des stationären Feldes verlaufenden Magnetfeldern mit Gradienten in der gleichen Richtung sowie senkrecht dazu, einer Abtasteinrichtung zum Empfangen von in einem Untersuchungsbereich erzeugten Echosignalen, mit einer Steuereinheit zur Steuerung der Gradientenspulen, der Hochfrequenz-Spulenanordnung und der Abtasteinrichtung, sowie mit einer Rekonstruktionseinheit, die aus den Echosignalen ein Bild der räumlichen Kernspinverteilung errechnet, und sie ist dadurch gekennzeichnet, daß die Steuereinheit so programmiert ist, daß jede Sequenz zweimal durchgeführt wird, wobei die Gradientenspulen so gesteuert sind, daß sich der Abstand zwischen dem Echosignal und dem Hochfrequenzimpuls um eine Zeitspanne entspricht, die der Hälfte des Kehrwertes der Differenz zwischen der Fett- und Wasserfrequenz entspricht, und daß die Rekonstruktionseinheit so ausgebildet ist, daß sie das Bild mittels der Summe bzw. der Differenz der Echosignale bestimmt.

Eine Anordnung zur Durchführung des anderen Verfahrens umfaßt Mittel zur Erzeugung eines stationären homogenen Magnetfeldes, eine Hochfrequenz-Spulenanordnung zur Erzeugung von Hochfrequenzimpulsen, Gradientenspulen zur Erzeugung von in Richtung des stationären Feldes verlaufenden Magnetfeldern mit Gradienten in der gleichen Richtung sowie senkrecht dazu, eine Abtasteinrichtung zum Empfangen von in einem Untersuchungsbereich erzeugten Echosignalen, mit einer Steuereinheit zur Steuerung der Gradientenspulen, der Hochfrequenz-Spulenanordnung und der Abtasteinrichtung, sowie mit einer Rekonstruktionseinheit, die aus den Echosignalen ein Bild der räumlichen Kernspinverteilung errechnet, und sie ist dadurch gekennzeichnet, daß die Steuereinheit so programmiert ist, daß jede Sequenz zwei Lesephasen umfaßt, in denen das Gradientenfeld jeweils die gleiche Richtung hat, daß den Lesephasen je ein Zeitraum vorangeht, in dem das Gradientenfeld jeweils in der entgegengesetzten Richtung verläuft wie in der Lesephase, und daß der zeitliche Verlauf des Gradientenfeldes so gewählt ist, daß sich das in der zweiten Lesephase auftretende Echosignal gegenüber dem in der ersten Lesephase auftretende Echosignal um einen Zeitraum verschiebt, der der Hälfte des Kehrwertes der Differenz der Larmorfrequenzen von an Wasser bzw. an Fett gebundenen Wasserstoffprotonen bzw. einem ungeradzahligen Vielfachen davon entspricht und daß die Rekonstruktionseinheit so ausgebildet ist, daß sie das Bild mittels der Summe bzw. der Differenz der Echosignale bestimmt.

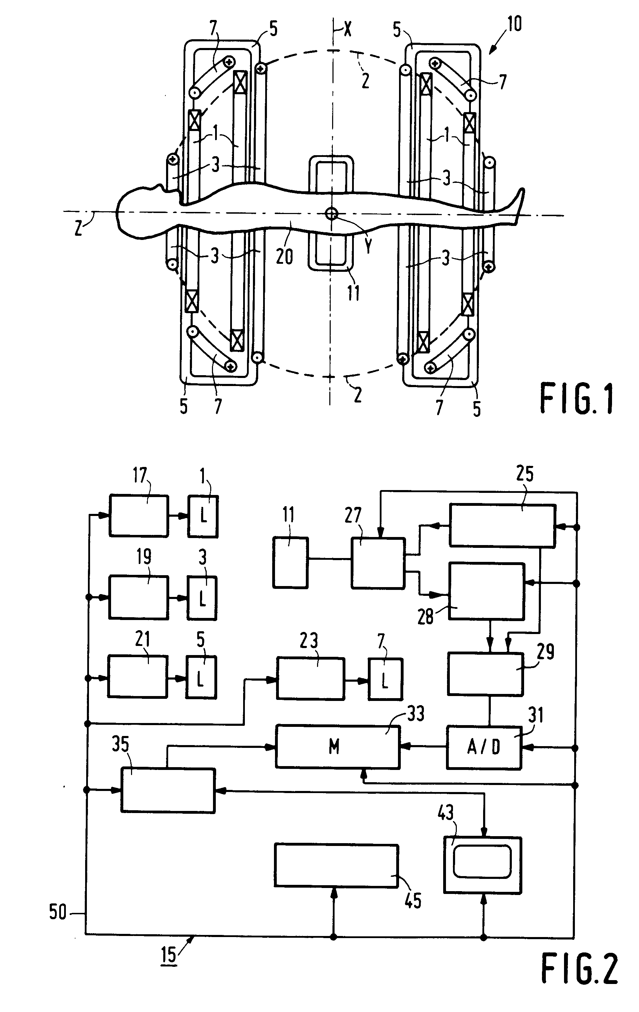

Die Erfindung wird nachstehend anhand der Zeichnung näher erläutert. Es zeigen:
Fig. I
die räumliche Lage der bei einem Kernspintomographen zur Erzeugung der verschiedenen Magnetfelder erforderlichen Spulenanordnungen,
Fig. 2
ein Blockschaltbild eines solchen Kernspintomographen,
Fig. 3
ein Blockschaltbild eines Teils der in Fig. 2 dargestellten Anordnung,
Fig. 4a und 4b
den zeitlichen Verlauf verschiedener Magnetfelder
bzw. Signale,
Fig. 5a und 5b

ein Vektordiagramm der Echosignale zu verschiedenen Zeitpunkten.

Das in Fig. I dargestellte Spulensystem enthält vier Hauptspulen I, die auf der Oberfläche einer Kugel 2 angeordnet sind, deren Mitte im Ursprung des dargestellten kartesischen x,y,z-Koordinatensystems liegt, wobei die Achsen der Hauptspulen I mit der Z-Achse zusammenfallen. Die vier Spulen bilden einen Magneten, der ein in z-Richtung verlaufendes homogenes stationäres Magnetfeld erzeugt. Die Induktion dieses Magnetfeldes kann einige T betragen, wenn supraleitende Spulen verwendet sind; anderenfalls beträgt die Induktion im allgemeinen weniger als IT.

Zur Erzeugung eines in z-Richtung verlaufenden magnetischen Gradientenfeldes Gz, d.h. eines Magnetfeldes, das ebenfalls in z-Richtung verläuft und in dieser Richtung einen konstanten Gradienten aufweist, sind vier Spulen 3 vorzugsweise auf der gleichen Kugeloberflächeangeordnet. Vier weitere Spulen 7 erzeugen einen ebenfalls in z-Richtung verlaufendes Magnetfeld Gx mit einem konstanten Gradienten in x-Richtung. Schließlich sind noch vier weitere Spulen 5 vorgesehen, die mit den Spulen 7 identisch sein können, die diesen gegenüber jedoch um 90° versetzt angeordnet sind. In der Zeichnung sind nur zwei dieser vier Spulen 5 dargestellt, die ein ebenfalls in z-Richtung verlaufendes Magnetfeld Gy mit einem Gradienten in y-Richtung erzeugen.

Weiterhin ist eine Hochfrequenzspule II symmetrisch zur Ebene z = 0 des Koordinatensystems angeordnet. Sie ist so gestaltet, daß damit ein im wesentlichen homogenes, in x-Richtung verlaufendes hochfrequentes Magnetfeld erzeugt wird.

Die Ströme für die Spulen I, 3, 5 und 7 werden von Generatoren I7, I9, 2I bzw. 23 erzeugt, die von einer zentralen Steuereinheit 45 gesteuert werden. Diese steuert weiter einen Hochfrequenzgenerator 25, einen Umschalter 27, über den der Hochfrequenzgenerator 25 mit der Hochfrequenzspule II koppelbar ist, einen ein- und ausschaltbaren Verstärker 28, der in der Lesephase, die von der Hochfrequenzspule II aufgenommenen Echosignale verstärkt, einen Analog-Digital-Wandler 31, der die vom Verstärker 28 verstärkten und von einem nachgeschalteten Quadratur-Demodulator 29 demodulierten Signale in eine Folge von digitalen Abtastwerten umsetzt, und einen Speicher 33, der die Digitalwerte aufnimmt. Aus den gespeicherten Werten berechnet ein Rechner 35 - beispielsweise durch Fourier-Transformation - die räumliche Kernspinverteilung und gibt diese auf einem Monitor 43 wieder.

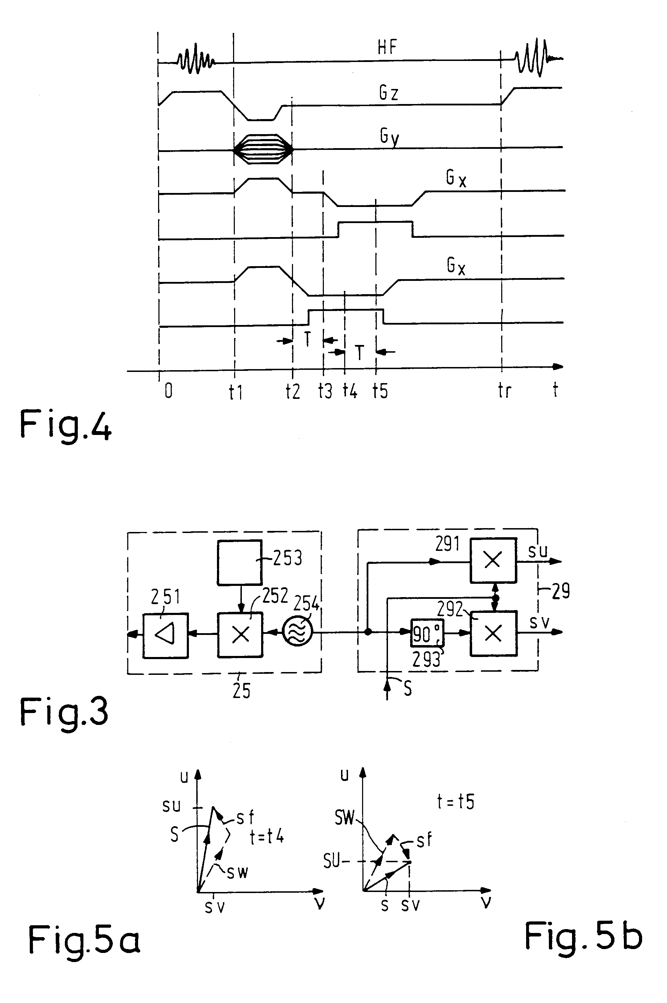

Die Funktion des Kernspintomographen wird nachfolgend anhand von Fig. 4a erläutert. In Fig. 4a stellt die letzte Zeile die Zeitachse dar, während in der ersten Zeile der zeitliche Verlauf der Hoch-

frequenzimpulse dargestellt ist. Der Hochfrequenz-impuls von dem Hochfrequenzgenerator 25 erzeugt. Dieser enthält (vgl. Fig. 3) einen Verstärker 25l, dessen Ausgang über die Umschaltvorrichtung 27 mit der Hochfrequenzspule II koppelbar ist und dessen Eingang mit einer Mischstufe 252 verbunden ist. Die Mischstufe 252 erzeugt an ihrem Ausgang ein Signal, das dem Produkt der Signale an ihren beiden Eingängen proportional ist, von denen der eine mit einem Hüllkurvengenerator 253 und der andere mit einem Oszillator 254 verbunden ist. Der Oszillator 254 ist auf die Larmorfrequenz der an Wasser gebundenen Wasserstoffprotonen abgestimmt (rund 85 MHz bei einer Induktion des stationären Feldes von 2T). Der Hüllkurvengenerator 253 umfaßt - nicht näher dargestellt - einen Digitalspeicher sowie einen Digital-Analog-Wandler, der die Ausgangssignale des Speichers in einen Analogwert umsetzt. Der von der Steuereinheit 45 gesteuerte Speicher enthält als Folge digitaler Abtastwerte ein Hüllkurvensignal.

Das Hüllkurvensignal ist so bemessen, daß der durch die Multiplikation des Hüllkurvensignals mit dem Oszillatorsignal erzeugte, durch den Verstärker 25l verstärkte Hochfrequenzimpuls einen Flipwinkel von 20° aufweist, so daß die Magnetisierung im Untersuchungsbereich um diesen Winkel aus der z-Richtung gekippt wird.

Der Generator l9 wird von der Zentraleinheit 45 so gesteuert, daß die Spulen 3 zur Zeit t = 0 ein Gradientenfeld Gz zu erzeugen beginnen, das wäh-rend des Hochfrequenzimpulses einen vorgegebe-nen Wert hat und das im Anschluß an den Hochfrequenzimpuls (zur Zeit t = tl) auf den Wert 0 abnimmt. Durch das Anlegen dieses Gradienten wird erreicht, daß der Hochfrequenzimpuls lediglich eine zur z-Achse senkrechte Schicht bzw. Volumen angeregt wird, dessen Dicke von der Bandbreite der Hochfrequenzimpulse und von dem Gradienten des Magnetfeldes Gz abhängt. Da in dem Zeitraum von t = 0 bis t = tl somit eine Schicht bzw. ein Volumen selektiert wird, wird sie auch Selektionsphase genannt.

Die Generatoren l9, 2l und 23 werden so gesteuert, daß in der darauf folgenden Phase alle drei Spulenanordnungen 3, 5 und 7 ein magnetisches Gradientenfeld Gz,Gy bzw.Gx erzeugen. Der Gradient des Gradientenfeldes Gz ist in dieser Phase dem Gradienten in der Selektionsphase (0-tl) entgegengesetzt. Es ist so bemessen, daß das zeitliche Integral über den Gradienten von der Mitte des Hochfrequenzimpulses bis zum Zeitpunkt t2 gleich 0 ist. Dadurch wird eine Rephasierung der Kernmagnetisierung in der angeregten Schicht erreicht.

Weiterhin wird der Generator 2l so gesteuert, daß die Gradientenspulen 5 im Zeitraum tl-t2 ein Gradientenfeld Gy erzeugen. Dieses Gradientenfeld bewirkt, daß die Phase der Magnetisierung von der Kernspinverteilung in y-Richtung abhängt. Der Zeitraum tl-t2 wird daher auch als Phasenkodierungs- oder Präparationsphase bezeichnet. Bei verschiedenen Sequenzen ist der Gradient Gy unterschiedlich groß.

Schließlich wird auch der Generator 23 von der Steuereinheit 45 so gesteuert, daß die Spulen 7 in der Präparationsphase ein magnetisches Gradientenfeld Gx erzeugen (vgl. sechste Zeile von Fig. 4a). Der Zweck dieser Maßnahme wird noch weiter unten näher erläutert. Am Ende der Präparationsphase, d.h. zur Zeit t = t2, haben alle Gradientenfelder Gx, Gy und Gz den Wert Null.

In der darauf folgenden Phase, der sogenannten Lesephase, wird lediglich der Generator 23 von der Steuereinheit 45 gesteuert, und zwar so, daß das Gradientenfeld Gx unmittelbar nach dem Ende der Lesephase sein Vorzeichen umkehrt (vgl. sechste Zeile). Durch das Gradientenfeld Gx in der Präparationsphase wird die Kernmagnetisierung im Untersuchungsbereich dephasiert. Diese Dephasierung wird in der Lesephase rückgängig gemacht, weil das Vorzeichen des Gradientenfeldes Gx umgekehrt wird. Es entsteht daher ein Echosignal, das zur Zeit t = t4, d.h. zu dem Zeitpunkt, in dem das zeitliche Integral über das Feld Gx den Wert Null erreicht, sein Maximum annimmt. Das Echosignal wird symmetrisch zum Zeitpunkt t = t4 abgetastet (vgl. siebte Zeile) und in eine Folge von digitalen Abtastwerten umgesetzt.

Erfindungsgemäß wird jede Sequenz mit dem-selben Hochfrequenzimpuls (erste Zeile), demsel-ben Selektionsgradienten Gz (zweite Zeile), demselben Kodierungsgradienten Gy, jedoch mit geändertem Lesegradienten Gx wiederholt. Die Änderung des Gradienten ist dabei derart, daß das Maximum des Echos zur Zeit t = t5, d.h. um die Zeitspanne T später (oder früher), auftritt, als in der vorangegangenen Sequenz. Dies wird dadurch erreicht, daß bei der Wiederholung der Sequenz in der Lesephase das Gradientenfeld nicht sofort eingeschaltet wird, sondern - wie sich aus der vierten Zeile von Fig. 4a ergibt - erst zum Zeitpunkt t = t3, wobei die Beziehung gilt:

$$t3-t2 = T.$$

Dementsprechend wird das Echosignal auch um die Zeit T später abgetastet (vgl. fünfte Zeile). Die Zeitspanne T um die der zeitliche Abstand zwischen dem Hochfrequenzimpuls und dem erwähnten Echo vergrößert bzw. verkleinert wird, muß dabei der Beziehung genügen:

$$T = 0,5/df.$$

df ist dabei die Differenz zwischen Wasser- und Fett- frequenz. Dies bedeutet, daß die Zeitspanne T gleich der Hälfte des Kehrwertes der Differenz von Wasser- und Fett- frequenz sein muß. Diese Differenz beträgt bei einem Feld mit 2T rund 28l Hz, so daß sich als die Hälfte des Kehrwertes dieser Differenz ein Wert von rund l,8 ms ergibt.

Es leuchtet ein, daß die Verschiebung des Echos gegenüber dem Hochfrequenzimpuls um die Zeitspanne T auch auf andere Weise erreicht werden kann. Eine Möglichkeit zur Verzögerung des Echos besteht in einer Verringerung des Gradienten Gx in der Lesephase oder in seiner Vergrößerung während der Präparationsphase. Das gleiche läßt sich auch erreichen, wenn die Dauer des Gradienten Gx in der Präparationsphase verringert oder vergrößert wird.

In Fig. 5a bzw. Fig. 5b ist das sich bei der ersten bzw. der zweiten Sequenz ergebende Echosignal zur Zeit t = t4 bzw. t = t5 als Vektor s in einem mit der Larmorfrequenz bzw. der Frequenz des Oszillators 254 mitrotierenden u, v-Koordinatensystems dargestellt, woraus sich die Phasenverschiebung des Signals s gegenüber der vom Oszillator 254 erzeugten Schwingung ergibt.

Jedes der beiden Echosignale s setzt sich, wie gestrichelt angedeutet, aus einem Anteil sw zusammen, der von der Wasserverteilung beeinflußt wird, und einem Anteil sf, der von der Fettverteilung beeinflußt wird. Die Phasenlage des Wasseranteils sw ist bei der Sequenz zur Zeit t = t4 genauso groß wie in der zweiten Sequenz zur Zeit t = t5, weil die Frequenz des Oszillators 254 der Larmorfrequenz von an Wasser gebundenen Wasserstoffprotonen entspricht. Hingegen weicht die Phasenlage des Fettanteils in beiden Diagrammen um l80° voneinander ab. Der Fettanteil könnte also eliminiert werden, indem die beiden Signale s vektoriell addiert werden, während der Wasseranteil unterdrückt werden könnte, wenn die beiden Signale voneinander subtrahiert würden. Die vektorielle Addition bzw. Subtraktion erfolgt bekanntlich dadurch, daß die Signale su, die der Projektion des Signals s auf die u-Achse entsprechen, addiert (bzw. subtrahiert) werden und daß die Signale sv die den Projektionen des Vektors s auf die v-Achse entsprechen, getrennt davon ebenfalls einander addiert bzw. voneinander subtrahiert werden.

Die Signale su und sv werden in dem Demodulator 29 aus dem Signal s erzeugt. Der Demodulator 29 enthält (vgl. Fig.3) zwei identisch aufgebaute Mischstufen 29l, 292. Das Ausgangssignal jeder Mischstufe ist dem Produkt der Signale an ihren beiden Eingängen proportional. Der andere Eingang der Mischstufe 29l ist direkt mit dem Ausgang des Oszillators 254 verbunden (bzw. dem Ausgang eines damit synchronisierten Oszillators), während der andere Eingang der Mischstufe 292 über ein 90°-Phasendrehglied mit dem Oszillator verbunden ist. Die bei dieser Mischung an den Mischerausgängen auftretenden Signale mit der doppelten Frequenz werden durch nicht näher dargestellte Tiefpaßfilter unterdrückt. Aufgrund der Mischung enthalten die gefilterten Signale su und sv keine Anteile mit der Oszillatorfrequenz.

Die niederfrequenten Signale su und sv werden durch den Analog-Digital-Wandler in je eine Folge digitaler Abtastwerte umgesetzt und gespeichert. Die Abtastwerte werden zu den Abtastwerten der entsprechenden Folge, die sich aus dem Echosignal der anderen Sequenz ergibt, addiert (oder subtrahiert), so daß zwei Folgen von summierten (oder subtrahierten) Abtastwerten entstehen. Diese werden zusammen mit den Folgen, die sich bei weiteren Sequenz-Paaren mit jeweils verändertem Kodierungsgradienten ergeben, in bekannter Weise einer Fourier-Transformation unterzogen, die für jedes Bildelement wiederum zwei Komponenten ergibt, aus denen durch Betragsbildung der zugehörige Bildwert bestimmt wird.

Der zeitliche Abstand tr zwischen zwei Sequenzen kann dabei 30 ms betragen. Nach so kurzer Zeit ist die vor Beginn der Messungen bestehende, in z-Richtung verlaufende Magnetisierung im Untersuchungsbereich noch nicht völlig wieder hergestellt. Infolgedessen ist bei der auf eine erste Sequenz folgenden Sequenz das Echosignal geringer und es verringert sich von Sequenz zu Sequenz. Nach etwa 20 bis 30 Sequenzen ist jedoch ein stationärer Zustand erreicht, von dem an die Amplitude der Echosignale nicht mehr wesentlich abnimmt. Wenn nur die Echosignale zur Rekonstruktion verwendet werden, die nach dem Erreichen des stationären Zustandes erfaßt wurden, ergeben sich keine Verfälschungen. Das Signal-Rauschverhältnis hängt dabei von dem Flipwinkel des Hochfrequenzimpulses ab. Das günstigste Signal-Rauschverhältnis ergibt sich, wenn für den Flipwinkel a die Beziehung gilt:

$$a = arc\ cos(exp(-tr/Tl)),$$

wobei Tl die longitudinale Relaxationszeit darstellt. Im allgemeinen ergibt sich der optimale Kontrast jedoch erst bei größeren Flipwinkeln, so daß in der Regel mit einem größeren Flipwinkel gearbeitet wird als sich aus der oben genannten Formel ergibt, der jedoch in der Regel deutlich kleiner ist als 90°.

Wie bereits erläutert, müssen die Signale zwecks Erzeugung eines Wasserbildes addiert werden - wenn die Oszillatorfrequenz der Larmorfrequenz von an Wasser gebundenen Wasserstoffprotonen entspricht. Wird der Oszillator jedoch auf die Larmorfrequenz von an Fett gebundenen Wasserstoffprotonen abgestimmt , müssen die Signale zur Erzeugung eines Wasserbildes voneinander subtrahiert (und zur Erzeugung eines Fettbildes zueinander addiert) werden. Jedoch könnte der Oszillator auch auf eine zwischen diesen beiden Frequenzen liegende Frequenz abgestimmt sein, z.B. genau auf die Mittenfrequenz. Die gewünschten Signale könnten auch in diesem Fall dadurch erhalten werden, daß zwischen den beiden zusammen ein Paar bildenden Sequenzen die Phase der dem Demodulator 29 zugeführten Oszillatorschwingung um $90^\circ$ umgeschaltet wird.

Man erkennt aus der vierten Zeile von Fig. 4a, daß es nicht darauf ankommt, daß der dem Lesegradienten in entgegengesetzter Richtung voraufgehende Gradient in der Präparationsphase tl-t2 ein- und ausgeschaltet wird; es genügt, wenn er zur Zeit t = t3 endet. Der zeitliche Abstand zwischen dem Beginn der Schwingung des Gradientenfeldes in der vierten Zeile wäre dann um den Wert T größer als der entsprechende Abstand in der sechsten Zeile. Wenn der Zeitraum T wesentlich größer und/oder die Dauer der erwähnte Schwingung des Gradientenfeldes wesentlich kürzer wäre, könnte der erwähnte Abstand in der vierten Zeile um die Dauer der Schwingung des Gradientenfeldes in der sechsten Zeile - oder mehr - größer sein als der entsprechende Abstand in der sechsten Zeile. Dann könnten beide Schwingungen aber in einer einzigen Sequenz enthalten sein, wie in Fig. 4b dargestellt.

Bei der anhand von Fig. 4b erläuterten Ausführungsform des Verfahrens umfaßt jede Sequenz einen Hochfrequenzimpuls im Zeitraum 0-tl (wie in der ersten Zeile von Fig. 4a), anschließend gegebenenfalls eine Kodierungsphase tl-t2 mit in y-Richtung verlaufendem Gradientenfeld (wie in Zeile drei von Fig. 4b), wobei ein der Schichtselektion dienendes Feld im Intervall 0-t2 wirksam ist (vgl. Zeile zwei von Fig. 4a). Diese Teile der Sequenz sind daher in Fig. 4a nicht noch einmal dargestellt. Im Zeitraum tl-t2 wird auch ein Gradient Gx eingeschaltet, der in der Lesephase t2-t3$'$ die entgegengesetzte Richtung aufweist, wobei das zeitliche Integral über Gx von tl bis zur Mitte der Lesephase Null ist. In der Lesephase wird das entstehende erste Echosignal abgetastet (zweite Zeile). Auf die erste Lesephase folgt ein Zeitraum (t3$'$-t4$'$), in dem das Gradientenfeld Gx wieder das entgegengesetzte Vorzeichen hat wie in der ersten Lesephase, woran sich eine zweite Lesephase (t4$'$-t5$'$) anschließt, in der der Lesegradient wieder die gleiche Richtung und das gleiche zeitliche Integral aufweist wie in der ersten Lesephase und in der das entstehende zweite Echosignal abgetastet wird (zweite Zeile). Der zeitliche Abstand der Mitten der beiden Lesephasen entspricht dabei dem Wert T$'$, wobei die Beziehung gilt:

$$T' = (2n-l)/(2df),$$

wobei n eine ganze Zahl größer als Null, vorzugsweise n = l ist.

Dieses Verfahren hat zwar gegenüber dem in Fig. 4a erläuterten Verfahren den Vorteil, daß die Zahl der Sequenzen nur halb so groß ist, doch kann gegenüber dem in Fig. 4a dargestellten Verfahren ein Verlust an räumlichen Auflösungsvermögen nur verhindert werden, wenn das zeitliche Integral über den Gradienten in der Lesephase nicht verändert wird. Es ist daher in der Regel nur anwendbar, wenn der Zeitraum T$'$ (für n = l) genügend groß ist. Das ist der Fall, wenn das stationäre homogene Magnetfeld schwächer ist, weil die Frequenzdifferenz df proportional mit der Feldstärke abnimmt. Bei einem Feld von 0,5 T beträgt der Zeitraum T$'$ schon 7,l sec.

In Fig. 4a bzw. 4b ist die Erfindung mit einem für das sogenannte 2DF-Verfahren (Zweidimensionales Fourierverfahren) geeigneten zeitlichen Verlauf der Gradientenfelder dargestellt. Die Erfindung kann jedoch auch bei anderen Verfahren angewandt werden, z.B. bei dem sogenannten Projektions-Rekonstruktionsverfahren, bei dem in der Kodierungsphase mehrere Gradientenfelder so geschaltet werden, daß der Betrag des Gradienten für alle Sequenzen gleich bleibt, während die Richtung des Gradienten geändert wird. In diesem Fall müßte in der Lesephase der Gradient jeweils in der entgegengesetzten Richtung verlaufen. - Ebenso ist es möglich, die Kernspinverteilung in einem dreidimensionalen Raum zu erfassen, z.B. durch das sogenannte 3DF-Verfahren (Dreidimensionales Fourierverfahren). Bei diesem Verfahren unterscheidet sich die Sequenz von der in Fig. 4a bzw. 4b dargestellten Sequenz dadurch, daß außer dem Gradientenfeld Gy auch noch das Gradientenfeld Gz in der Codierungsphase variiert wird.

Im vorstehenden wurde davon ausgegangen, daß zunächst die zusammen ein Paar bildenden Sequenzen erzeugt werden und daß die Summe bzw. die Differenz der dabei entstehenden Echosignale gebildet wird. Es ist jedoch auch möglich, aus einer Folge von Sequenzen mit jeweils gleichem Abstand zwischen Hochfrequenzimpuls und Echosignal zunächst in bekannter Weise ein erstes Bild zu erzeugen (ohne allerdings für die einzelnen Bildpunkte den Betrag zu bilden). Das gleiche wird für eine zweite Folge mit der gleichen Anzahl von Sequenzen durchgeführt, bei denen der Abstand zwischen dem Hochfrequenzimpuls und dem Echoimpuls jedoch um die Zeitspanne T größer oder kleiner ist, und es wird daraus ebenfalls ein Bild rekonstruiert (wiederum ohne Betragsbildung für die Bildwerte der einzelnen Bildpunkte). Da die Rekonstruktionsverfahren, beispielsweise die Fourierrekonstruktion, ein linearer Signalverarbeitungsprozeß sind, erhält man das gleiche Ergebnis wie zuvor, wenn man die beiden Bilder Bildpunkt für Bildpunkt zueinander addiert bzw. voneinander subtrahiert und erst dann den Betrag bildet. Allerdings erfordert dieses Verfahren mehr Speicherplatz und eine längere Rekonstruktionszeit. Auf der anderen Seite lassen sich nachträglich sowohl ein Fettbild als auch ein Wasserbild erzeugen.

**Patentansprüche**

1. Kernspintomographieverfahren, bei dem in einer Vielzahl von Sequenzen Echosignale für die Rekonstruktion der räumlichen Dichteverteilung in einem Untersuchungsbereich gewonnen werden, wobei jede Sequenz eine Selektionsphase $(0\text{-}t_1)$, in der ein einziger Hochfrequenzimpuls in Anwesenheit eines ersten magnetischen Gradientenfeldes (Gz) in den Untersuchungsbereich eingestrahlt wird, eine darauf folgende Kodierungsphase $(t_1\text{-}t_2)$, in der ein zweites magnetisches Gradientenfeld (Gy) mit von Sequenz zu Sequenz nach Betrag bzw. Richtung verändertem Gradienten auf den Untersuchungsbereich einwirkt und eine daran anschließende Lesephase umfaßt, in der in Anwesenheit eines dritten magnetischen Gradientenfeldes (Gx) das im Untersuchungsbereich erzeugte Kernspin-Echosignal abgetastet wird, wonach aus dem Echosignal ein von der Protonenverteilung abhängiges Bild errechnet wird, wobei als letzter Schritt die Bildwerte für die einzelnen Bildpunkte des Bildes durch Betragsbildung ermittelt werden, dadurch gekennzeichnet, daß jede Sequenz zweimal durchgeführt wird, daß bei der zweiten Sequenz das dritte Gradientenfeld (Gx) in der Lesephase bzw. das zuvor in entgegengesetzter Richtung verlaufende Gradientenfeld so bemessen sind, daß sich der zeitliche Abstand zwischen dem Hochfrequenzimpuls und dem Echosignal gegenüber der ersten Sequenz um einen Zeitraum (T) verschiebt, der gleich der Hälfte des Kehrwertes der Differenz der Larmorfrequenzen (df) von an Wasser bzw. an Fett gebundenen Wasserstoffprotonen ist, und daß aus den Summen oder den Differenzen der bei den beiden Sequenzen gebildeten Echosignale ein Bild der Dichteverteilung im Untersuchungsbereich berechnet wird.

2. Kernspintomographieverfahren, bei dem in einer Vielzahl von Sequenzen Echosignale für die Rekonstruktion der räumlichen Dichteverteilung in einem Untersuchungsbereich gewonnen werden, wobei jede Sequenz eine Selektionsphase $(0\text{-}t_1)$, in der ein einziger Hochfrequenzimpuls in Anwesenheit eines magnetischen Gradientenfeldes (Gz) in den Untersuchungsbereich eingestrahlt wird, eine darauf folgende Kodierungsphase $(t_1\text{-}t_2)$, in der ein magnetisches Gradientenfeld (Gy) mit von Sequenz zu Sequenz nach Betrag bzw. Richtung verändertem Gradienten auf den Untersuchungsbereich einwirkt und eine daran anschließende Lesephase umfaßt, in der in Anwesenheit eines magnetischen Gradientenfeldes (Gx) das im Untersuchungsbereich erzeugte Kernspin-Echosignal abgetastet wird, wonach aus dem Echosignal ein von der Protonenverteilung abhängiges Bild errechnet wird, wobei als letzter Schritt die Bildwerte für die einzelnen Bildpunkte des Bildes durch Betragsbildung ermittelt werden, dadurch gekennzeichnet, daß jede Sequenz zwei Lesephasen $(t2\text{-}t3'; t4'\text{-}t5')$ umfaßt, in denen das Gradientenfeld jeweils die gleiche Richtung hat, daß den Lesephasen je ein Zeitraum vorangeht, in dem das Gradientenfeld jeweils in der entgegengesetzten Richtung verläuft wie in der Lesephase und daß der zeitliche Verlauf des Gradientenfeldes (Gx) so gewählt ist, daß sich das in der zweiten Lesephase auftretende Echosignal gegenüber dem in der ersten Lesephase auftretenden Echosignal um einen Zeitraum $(T')$ verschiebt, der der Hälfte des Kehrwertes der Differenz der Larmorfrequenzen (df) von an Wasser bzw. an Fett gebundenen Wasserstoffprotonen bzw. einem ungeradzahligen Vielfachen davon entspricht, und daß aus den Summen oder den Differenzen der bei den beiden Sequenzen gebildeten Echosignale ein Bild der Dichteverteilung im Untersuchungsbereich berechnet wird.

3. Verfahren nach Anspruch I, dadurch gekennzeichnet, daß das Gradientenfeld in der Lesephase bei beiden Sequenzen die gleiche Größe hat und daß der zeitliche Abstand des Gradientenfeldes in der Lesephase von dem Hochfrequenzimpuls bei der einen Sequenz um einen Zeitraum (T) größer ist als bei der anderen Sequenz, der der Hälfte des Kehrwertes der Differenz der Larmorfrequenzen von an Wasser bzw. Fett gebundenen Wasserstoffprotonen ist.

4. Verfahren nach Anspruch I, dadurch gekennzeichnet, daß in der Lesephase das Gradientenfeld der einen Sequenz größer ist als in der anderen Sequenz.

5. Verfahren nach einem der vorhergehenden Ansprüche, dadurch gekennzeichnet, daß der Flipwinkel des Hochfrequenzimpulses kleiner ist als $90°$, daß die Zeit zwischen dem Beginn einer Sequenz und dem Beginn der nächsten Sequenz kleiner ist als l00 ms und daß die Echosignale, die entstehen, bevor die Magnetisierung einen stationären Zustand erreicht hat, unterdrückt werden.

6. Anordnung zur Durchführung des Verfahrens nach Anspruch l mit Mitteln (l) zur Erzeugung eines stationären homogenen Magnetfeldes, einer Hochfrequenz-Spulenanordnung (ll) zur Erzeugung von Hochfrequenzimpulsen, Gradientenspulen (3, 5, 7) zur Erzeugung von in Richtung des stationären Feldes verlaufenden Magnetfeldern mit Gradienten in der gleichen Richtung sowie senkrecht dazu, einer Abtasteinrichtung (28...3l) zum Empfangen von in einem Untersuchungsbereich erzeugten Echosignalen, mit einer Steuereinheit (45) zur Steuerung der Gradientenspulen, der Hochfrequenz-Spulenanordnung und der Abtasteinrichtung, sowie mit einer Rekonstruktionseinheit (35), die aus den Echosignalen ein Bild der räumlichen Kernspinverteilung errechnet, dadurch gekennzeichnet, daß die Steuereinheit (45) so programmiert ist, daß jede Sequenz zweimal durchgeführt wird, wobei die Gradientenspulen (3, 5, 7) so gesteuert sind, daß sich der Abstand zwischen dem Echosignal und dem Hochfrequenzimpuls um eine Zeitspanne (T) verschiebt, die der Hälfte des Kehrwertes der Differenz zwischen der Fett- und Wasserfrequenz entspricht, und daß die Rekonstruktionseinheit (33) so ausgebildet ist, daß sie das Bild mittels der Summe bzw. der Differenz der Echosignale bestimmt.

7. Anordnung zur Durchführung des Verfahrens nach Anspruch 2 mit Mitteln (l) zur Erzeugung eines stationären homogenen Magnetfeldes, einer Hochfrequenz-Spulenanordnung (ll) zur Erzeugung von Hochfrequenzimpulsen, Gradientenspulen (3, 5, 7) zur Erzeugung von in Richtung des stationären Feldes verlaufenden Magnetfeldern mit Gradienten in der gleichen Richtung sowie senkrecht dazu, einer Abtasteinrichtung (28...3l) zum Empfangen von in einem Untersuchungsbereich erzeugten Echosignalen, mit einer Steuereinheit (45) zur Steuerung der Gradientenspulen, der Hochfrequenz-Spulenanordnung und der Abtasteinrichtung, sowie mit einer Rekonstruktionseinheit (35), die aus den Echosignalen ein Bild der räumlichen Kernspinverteilung errechnet, dadurch gekennzeichnet, daß die Steuereinheit so programmiert ist, daß jede Sequenz zwei Lesephasen $(t2-t3'; t4'-t5')$ umfaßt, in denen das Gradientenfeld jeweils die gleiche Richtung hat, daß den Lesephasen je ein Zeitraum vorangeht, in dem das Gradientenfeld jeweils in der entgegengesetzten Richtung verläuft wie in der Lesephase, und daß der zeitliche Verlauf des Gradientenfeldes (Gx) so gewählt ist, daß sich das in der zweiten Lesephase auftretende Echosignal gegenüber dem in der ersten Lesephase auftretende Echosignal um einen Zeitraum $(T')$ verschiebt, der der Hälfte des Kehrwertes der Differenz der Larmorfrequenzen (df) von an Wasser bzw. an Fett gebundenen Wasserstoffprotonen bzw. einem ungeradzahligen Vielfachen davon entspricht und daß die Rekonstruktionseinheit (33) so ausgebildet ist, daß sie das Bild mittels der Summe bzw. der Differenz der Echosignale bestimmt.

**Claims**

1. A nuclear-spin tomography method wherein echo signals are extracted during a plurality of sequences for the reconstruction of the spatial density distribution in an examination region, each sequence including a selection phase (0-t1) during which a single high-frequency pulse is applied to the examination region in the presence of a first magnetic gradient field (Gz), a subsequent encoding phase (t1-t2) during which the examination region is exposed to a second magnetic gradient field (Gy) with a gradient with varies as regards magnitude or direction from one sequence to another, and a subsequent read phase during which the spin echo signal generated in the examination region is sampled in the presence of a magnetic gradient field (Gx), after which an image which is dependent on the proton distribution is calculated from the echo signal, the image values for the individual pixels of the image being determined by formation of the absolute value during a final step, characterized in that each sequence is executed twice, the third gradient field (Gx) during the read phase in the second sequence, or the gradient field previously extending in the opposite direction, being proportioned so that the distance in time between the high-frequency pulse and the echo signal is shifted with respect to the first sequence over a period of time (T) which corresponds to half the reciprocal value of the difference between the Larmor frequencies (df) of water-bound and fat-bound hydrogen protons, respectively, an image of the density distribution in the examination region being calculated from the sums of or the differences between the echo signals formed during the two sequences.

2. A nuclear-spin tomography method wherein echo signals are extracted during a plurality of sequences for the reconstruction of the spatial density distribution in an examination region, each sequence including a selection phase (0-t1) during which a single high-frequency pulse is applied to the examination region in the presence of a magnetic gradient field (G2), a subsequent encoding phase (t1-t2) during which the examination region is exposed to a magnetic gradient field (Gy) with a gradient which varies as regards magnitude or direction from one sequence to another, and a subsequent read phase during which the spin echo signal generated in the examination region is sampled in the presence of a magnetic gradient field (Gz), after which an image which is dependent on the proton distribution is calculated from the echo signal, the image values for the individual pixels of the image being determined by formation of the absolute value during a final step, characterized in that each sequence includes two read phases (t2-t3'; t4'-t5') during which the gradient field has the same direction, each of the read phases being preceded by a period of time during which the gradient field extends in the opposite direction with respect to its direction during the read phase, the variation in time of the gradient field (Gx) being chosen so that the echo signal occurring during the second read phase is shifted with respect to the echo signal occurring during the first read phase over a period of time (T') wich corresponds to half the reciprocal value of the difference between the Larmor frequencies (df) of water-bound and fat-bound hydrogen protons, respectively, or to an odd multiple thereof, an image of the density distribution in the examination region being calculated from the sums of or the differences between the echo signals formed during the two sequences.

3. A method as claimed in Claim 1, characterized in that the gradient field has the same magnitude during the read phase of both sequences, the distance in time between the gradient field and the high-frequency pulse in one sequence exceeding that in the other sequence by a period of time (T) which amounts to half the reciprocal value of the difference between the Larmor frequencies of water-bound and fat-bound hydrogen protons, respectively.

4. A method as claimed in Claim 1, characterized in that during the read phase the gradient field in one sequence is larger than that in the other sequence.

5. A method as claimed in any one of the preceding Claims, characterized in that the flip angle of the high-frequency pulse is smaller than 90˚, the period of time elapsing between the beginning of a sequence and the beginning of the next sequence being smaller than 100 ms, the echo signals which occur before the magnetization has reached a steady state being suppressed.

6. An arrangement for performing the method claimed in Claim 1, including means (1) for generating a steady, uniform magnetic field, a high-frequency coil system (11) for generating high-frequency pulses, gradient coils (3, 5, 7) for generating magnetic fields which extend in the direction of the steady field and which have gradients in the same direction as well as in the direction perpendicular theretol, a sampling device (28....31) for receiving echo signals generated in an examination region, a control unit (45) for controlling the gradient coils, the high-frequency coil system and the sampling device, as well as a reconstruction unit (35) which calculates an image of the spatial nuclear-spin distribution from the echo signals, characterized in that the control unit (45) is programmed so that each sequence is executed twice, the gradient coils (3, 5, 7) being controlled so that the distance between the echo signal and the high-frequency pulse is shifted over a period of time (T) which corresponds to half the reciprocal value of the difference between the fat frequency and the water frequency, the reconstruction unit (33) being constructed so that it determines the image on the basis of the sum of or the difference between the echo signals.

7. An arrangement for performing the method claimed in Claim 2, including means (1) for generating steady, uniform magnetic field, a high-frequency coil system (11) for generating high-frequency pulses, gradient coils (3, 5, 7) for generating magnetic fields which extend in the direction of the steady field and which have gradients in the same direction as well as in the direction perpendicular thereto, a sampling device (28....31) for receiving echo signals generated in an examination region, a control unit (45) for controlling the gradient coils, the high-frequency coil system and the sampling device, as well as a reconstruction unit (35) which calculates an image of the spatial nuclear-spin distribution from the echo signals, characterized in that the control unit is programmed so that each sequence includes two read phases (t2-t3'; t4'-t5') during which the gradient field has the same direction, each of the read phases being preceded by a period of time during which the gradient field extends in the opposite direction with respect to its direction during the read phase, the variation in time of the gradient field (Gx) being chosen so that the echo signal occurring during the second read phase is shifted with respect to the echo signal occurring during the first read phase over a period of time (T') which corresponds to half the reciprocal value of the difference between the Larmor frequencies (df) of water-bound and fat-bound hydrogen protons, respectively, or to an odd multiple thereof, the reconstruction unit (33) being constructed so that it determines the image on the basis of the sum of or the difference between the echo signals.

**Revendications**

1. Procédé de tomographie par spin nucléaire, suivant lequel, dans une pluralité de séquences, des signaux d'écho sont collectés pour la reconstruction de la distribution de densité dans l'espace dans un domaine d'examen, où chaque séquence comprend une phase de sélection (0-t1) pendant laquelle une impulsion de haute fréquence unique est émise en présence d'un premier champ magnétique de gradient (Gz) dans le domaine d'examen, une phase de codage (t1-t2) qui y succède, pendant laquelle un deuxième champ magnétique de gradient (Gy) agit sur le domaine d'examen avec des gradients modifiés en valeur absolue ou en direction de séquence à séquence et une phase de lecture qui y succède, pendant laquelle le signal d'écho de spin nucléaire engendré dans le domaine d'examen est échantillonné en présence d'un troisième champ magnétique de gradient (Gx), après quoi une image dépendant de la répartition des protons est calculée à partir du signal d'écho, et où, comme dernière opération, les valeurs d'image sont déterminées par formation de la valeur absolue pour les différents points de l'image, caractérisé en ce que chaque séquence est exécutée deux fois, que lors de la deuxième séquence, le troisième champ de gradient (Gx) dans la phase de lecture ou le champ de gradient s'étendant précédemment dans la direction opposée sont calculés de telle façon que la distance dans le temps entre l'impulsion de haute fréquence et le signal d'écho soit décalée par rapport à la première séquence d'une durée (T) qui est égale à la moitié de la valeur inverse de la différence des fréquences de Larmor (df) des protons liés à l'eau et aux lipides et qu'une image de la répartition de densité dans le domaine d'examen est calculée à partir des sommes ou des différences des signaux d'écho formés lors des deux séquences.

2. Procédé de tomographie par spin nucléaire, suivant lequel, dans une pluralité de séquences, des signaux d'écho sont collectés pour la reconstruction de la distribution de densité dans l'espace dans un domaine d'examen, où chaque séquence comprend une phase de sélection (0-t1), pendant laquelle une impulsion de haute fréquence unique est émise en présence d'un champ magnétique de gradient (Gz) dans le domaine d'examen, une phase de codage (t1-t2) qui y succède, pendant laquelle un champ magnétique de gradient (Gy) agit sur le domaine d'examen avec des gradients modifiés en valeur absolue ou en direction de séquence à séquence et une phase de lecture qui y succède, pendant laquelle le signal d'écho de spin nucléaire engendré dans le domaine d'examen est échantillonné en présence d'un champ magnétique de gradient (Gx), après quoi une image dépendant de la répartition des protons est calculée à partir du signal d'écho, et où, comme dernière opération, les valeurs d'image sont déterminées par calcul de la valeur absolue pour les différents points de l'image, caractérisé en ce que chaque séquence comprend deux phases de lecture (t2-t3'; t4'-t5') au cours desquelles le champ de gradient a chaque fois la même direction, que les phases de lecture sont chaque fois précédées d'une durée au cours de laquelle le champ de gradient s'étend chaque fois dans la direction opposée à celle de la phase de lecture et que l'évolution temporelle du champ de gradient (Gx) est choisie de façon que le signal d'écho apparaissant pendant la deuxième phase de lecture soit décalé d'une durée (T'), par rapport au signal d'écho apparaissant pendant la première phase de lecture, qui correspond à la moitié de la valeur inverse de la différence des fréquences de Larmor (df) des protons liés à l'eau et aux lipides soit un multiple impair de celle-ci et qu'une image de la répartition de densité dans le domaine d'examen est calculée à partir des sommes ou des différences des signaux d'écho formés pendant les deux séquences.

3. Procédé suivant la revendication 1, caractérisé en ce que le champ de gradient pendant la phase de lecture lors des deux séquences a la même grandeur et que la distance dans le temps du champ de gradient pendant la phase de lecture depuis l'impulsion de haute fréquence lors d'une séquence est plus grande que pendant l'autre séquence, et ce d'une durée (T) qui est la moitié de la valeur inverse de la différence des fréquences de Larmor des protons liés à l'eau et aux lipides.

4. Procédé suivant la revendication 1, caractérisé en ce que pendant la phase de lecture, le champ de gradient d'une séquence est plus intense que pendant l'autre séquence.

5. Procédé suivant l'une quelconque des revendications précédentes, caractérisé en ce que l'angle de basculement de l'impulsion de haute fréquence est inférieur à 90°, que le temps entre le début d'une séquence et le début de la séquence suivante est inférieur à 100 ms et que les signaux d'écho qui apparaissent avant que la magnétisation ait atteint un état stationnaire sont supprimés.

6. Appareil pour l'exécution du procédé suivant la revendication 1, qui comprend des moyens (1) pour produire un champ magnétique homogène statique, un montage de bobine de haute fréquence (11) pour produire des impulsions de haute fréquence, des bobines de gradient (3, 5, 7) pour produire des champs magnétiques s'étendant dans la direction du champ statique avec des gradients dans la même direction et perpendiculairement à celle-ci, un dispositif d'échantillonnage (28, ..., 31) pour recevoir les signaux d'écho produits dans une région d'examen, avec une unité de commande (45) pour commander les bobines de gradient, le montage de bobine de haute fréquence et le dispositif d'échantillonnage, de même qu'une unité de reconstruction (35) qui calcule, à partir des signaux d'écho, une image de la distribution des spins nucléaires dans l'espace, caractérisé en ce que l'unité de commande (45) est programmée de façon que chaque séquence soit exécutée deux fois, les bobines de gradient (3, 5, 7) étant commandées de façon que la distance entre le signal d'écho et l'impulsion de haute fréquence corresponde à une durée (T) correspondant à la moitié de l'inverse de la différence entre la fréquence des lipides et la fréquence de l'eau et que l'unité de reconstruction (35) est conçue de façon qu'elle détermine l'image au moyen de la somme ou de la différence des signaux d'écho.

7. Appareil pour l'exécution du procédé suivant la revendication 2, qui comprend des moyens (1) pour produire un champ magnétique homogène statique, un montage de bobine de haute fréquence (11) pour produire des impulsions de haute fréquence, des bobines de gradient (3, 5, 7) pour produire des champs magnétiques s'étendant dans la direction du champ statique avec des gradients dans la même direction et perpendiculairement à celle-ci, un dispositif d'échantillonnage (28, ..., 31) pour recevoir les signaux d'écho produits dans une région d'examen, avec une unité de commande (45) pour commander les bobines de gradient, le montage de bobine de haute fréquence et le dispositif d'échantillonnage, de même qu'une unité de reconstruction (35) qui calcule, à partir des signaux d'écho, une image de la distribution des spins nucléaires dans l'espace, caractérisé en ce que l'unité de commande est programmée de façon que chaque séquence comprenne deux phases de lecture (t2-t3'; t4'-t5') au cours desquelles le champ de gradient a chaque fois la même direction, que les phases de lecture sont chaque fois précédées d'un intervalle pendant lequel le champ de gradient s'étend chaque fois dans la direction opposée à celle de la phase de lecture et que l'évolution temporelle du champ de gradient (Gx) est choisie de façon que le signal d'écho apparaissant pendant la seconde phase de lecture soit décalé par rapport au signal d'écho apparaissant pendant la première phase de lecture d'un intervalle (T') qui correspond à la moitié de l'inverse de la différence des fréquences de Larmor des protons liés à l'eau ou aux lipides ou à un multiple impair de celle-ci et que l'unité de reconstruction (35) est conçue de façon qu'elle détermine l'image au moyen de la somme ou de la différence des signaux d'écho.

FIG.1

FIG.2

Fig.4

Fig.3

Fig.5a          Fig.5b